(19) **Europäisches Patentamt / European Patent Office / Office européen des brevets**

(11) **EP 4 632 091 A1**

(12) **EUROPEAN PATENT APPLICATION**
published in accordance with Art. 153(4) EPC

(43) Date of publication:
**15.10.2025 Bulletin 2025/42**

(21) Application number: **23900499.7**

(22) Date of filing: **27.11.2023**

(51) International Patent Classification (IPC):
**C22C 21/02** (2006.01)   **C22F 1/00** (2006.01)
**C22F 1/043** (2006.01)   **H01L 21/60** (2006.01)

(52) Cooperative Patent Classification (CPC):
**C22C 1/026; C22F 1/043; H01L 24/48; C22C 21/02**

(86) International application number:
**PCT/JP2023/042371**

(87) International publication number:
**WO 2024/122382 (13.06.2024 Gazette 2024/24)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority:   **05.12.2022   JP 2022194009**
   **30.06.2023   PCT/JP2023/024324**

(71) Applicants:
  • **NIPPON STEEL CHEMICAL & MATERIAL CO., LTD.**
    **Tokyo 103-0027 (JP)**
  • **Nippon Micrometal Corporation**
    **Iruma-shi**
    **Saitama 358-0032 (JP)**

(72) Inventors:
  • **UNO, Tomohiro**
    **Tokyo 100-8071 (JP)**
  • **ODA, Daizo**
    **Iruma-shi, Saitama 358-0032 (JP)**
  • **ETO, Motoki**
    **Iruma-shi, Saitama 358-0032 (JP)**
  • **SUTO, Yuya**
    **Iruma-shi, Saitama 358-0032 (JP)**

(74) Representative: **Grünecker Patent- und Rechtsanwälte**
    **PartG mbB**
    **Leopoldstraße 4**
    **80802 München (DE)**

(54) **AL CONNECTION MATERIAL**

(57)   To provide an Al connection material that may suppress generation of internal cracks at the time of manufacture and exhibits excellent temperature cycle reliability. The Al connection material containing 3.0% by mass or more and 12.0% by mass or less of Si, and containing 5 mass ppm or more and 800 mass ppm or less of one or more of Sr, Na, Eu, and Ca in total.

[Figure 1]

L CROSS-SECTION
(CROSS SECTION IN CENTER AXIS DIRECTION INCLUDING CENTER AXIS)

CENTER AXIS OF Al CONNECTION MATERIAL

**Description**

**TECHNICAL FIELD**

The present invention relates to an Al connection material.

**BACKGROUND**

In a semiconductor device, electrodes formed on a semiconductor chip are connected with a lead frame or electrodes on a substrate via a bonding wire (wire material) or a bonding ribbon (bar material). In a power semiconductor device, used is a bonding wire or a bonding ribbon made mainly of aluminum (Al) as a material. A wire diameter of the Al bonding wire mainly falls within a range from 100 $\mu$m to 600 $\mu$m. A width of the Al bonding ribbon mainly falls within a range from 100 $\mu$m to 3000 $\mu$m, and a thickness thereof falls within a range from 50 $\mu$m to 600 $\mu$m. Herein, the Al bonding wire and the Al bonding ribbon are collectively referred to as an Al connection material.

In the power semiconductor device, silicon (Si) is often used as a material of a semiconductor chip, and an Al-Si alloy or an Al-Cu alloy is often used as a material of the electrode formed on the semiconductor chip. Power semiconductor devices using the Al connection material are often used as large power equipment such as air conditioners and photovoltaic power generation systems, or as vehicle-mounted semiconductor devices.

A bonding method for the Al connection material includes 1st bonding with the electrode on the semiconductor chip and 2nd bonding with the lead frame or the electrode on the substrate, and wedge bonding is used for both of them. The wedge bonding is a method for applying ultrasonic vibrations and loads to the Al connection material via a jig (tool) made of metal, breaking surface oxide films of the Al connection material and an electrode material to expose new surfaces, and performing solid phase diffusion bonding. This connection method is characterized in that the connection material is connected in a solid phase state without being melted, which is a bonding technique different from a welding technique of melting the connection material.

A next-generation power semiconductor device is required to stably operate for a long time as compared with a general-purpose power semiconductor device. The power semiconductor device operates while repeatedly turning on and off a current. When a current is supplied to a semiconductor chip made of Si via the Al connection material, a temperature of a 1st bonding part rises. On the other hand, when supply of the current is stopped, the temperature of the 1st bonding part falls. In this way, the temperature of the 1st bonding part repeatedly rises and falls at the time when the power semiconductor operates. Accordingly, thermal stress, which is caused by a thermal expansion difference between the Al connection material and the semiconductor chip, is repeatedly applied to the 1st bonding part. In a case of using a connection material made only of high-purity Al, the Al connection material is broken in a relatively short time due to thermal stress, so that it has been difficult to satisfy performance required for the next-generation power semiconductor device. Thus, in the next-generation power semiconductor, it is required to improve a lifetime of wire (or ribbon) bond accompanying a temperature rise and a temperature fall of the 1st bonding part (hereinafter, also referred to as "temperature cycle reliability").

In response to the requirement for the temperature cycle reliability, there has been developed an Al connection material focused on improvement in mechanical strength. As a method for improving a mechanical characteristic of the Al connection material, there has been developed a method for adding a specific element to Al.

Patent Literature 1 discloses a bonding wire made of an Al alloy containing at least magnesium (Mg) and silicon (Si), in which a total content of Mg and Si is equal to or larger than 0.03% by mass and equal to or smaller than 0.3% by mass. This Patent Literature discloses that lowering of bonding strength of the 1st bonding part is delayed in a thermal cycle test in a temperature range from 70°C to 120°C due to a high-strengthening effect exhibited by solid-solution strengthening of Mg or Si, and an effect of suppressing crack development exhibited by precipitated magnesium silicide ($Mg_2Si$).

Patent Literature 2 discloses a bonding wire made of an alloy containing 0.01 to 0.2% by mass of iron (Fe), 1 to 20 mass ppm of silicon (Si), and Al having purity of 99.997% by mass or more as a balance, in which a solid solution amount of Fe is 0.01 to 0.06%, a precipitation amount of Fe is 7 times or less the Fe solid solution amount, and the bonding wire has a fine structure having an average crystal grain size of 6 to 12 $\mu$m. This Patent Literature discloses that it is possible to suppress lowering of bonding strength of a 1st bonding part in a thermal shock test within a temperature range from -50°C to 200°C by uniformly dispersing intermetallic compound particles of Fe and Al in Al to improve mechanical strength of a matrix and further refining recrystallized grains.

Patent Literature 3 discloses a bonding wire made by melting an Al-Si alloy containing 0.1 to 5% by mass of silicon (Si), and Al and impurities as a balance, and jetting and rapidly cooling it to be formed in a thin line. This Patent Literature discloses that mechanical strength is improved by rapidly cooling the melted Al-Si alloy to finely and uniformly disperse Si.

**RELATED ART REFERENCE**

**Patent Literature**

Patent Literature 1: Japanese Patent Application Laid-open No. 2014-131010
Patent Literature 2: Japanese Patent Application Laid-open No. 2014-129578
Patent Literature 3: Japanese Patent Application Laid-open No. S59-57440

**RELATED ART REFERENCE**

**PROBLEM TO BE SOLVED BY THE INVENTION**

As described above, the next-generation power semiconductor device is required to withstand a longer-time use as compared with a general-purpose power semiconductor device. The temperature of the 1st bonding part repeatedly rises and falls at the time when the power semiconductor device operates. As a result, because the Al connection material has a coefficient of linear thermal expansion larger than that of the semiconductor chip, there has been a case in which thermal stress is caused due to a difference between coefficients of linear thermal expansion thereof at the 1st bonding part, which finally causes fatigue breakdown of the Al connection material. A temperature cycle test is one of the tests for evaluating, in an accelerated manner, a lifetime of wire (or ribbon) bond accompanying a temperature rise and a temperature fall of the 1st bonding part (temperature cycle reliability). The Al connection material used for the next-generation power semiconductor is required to exhibit excellent temperature cycle reliability in the temperature cycle test. However, in a case of using the Al connection material that is highly strengthened by adding Si and the like thereto as disclosed in Patent Literatures 1 to 3, it has been confirmed that there is a problem in that a crack develops at a relatively high speed in an Al alloy electrode having lower strength than that of the Al connection material in a temperature cycle test assuming a use in the next-generation power semiconductor device, and favorable temperature cycle reliability is difficult to be stably obtained.
An Al alloy containing a high concentration of alloy elements causes lowering of processability, deterioration of a manufacturing yield, lowering of quality, and the like due to hardening, which hinders practical implementation. It has been found that, with the Al connection material that is highly strengthened by adding Si and the like thereto, a crack (hereinafter, referred to as an "internal crack") may be generated in the Al connection material at the time of wire-drawing processing. This may be caused by formation of coarse Si crystallized products, nonuniform plastic deformation of an Al phase, and the like. The internal crack may induce faults such as lowering of temperature cycle reliability or a melting fracture at the time when a large current is applied, so that there is a demand for suppressing generation of the internal crack.
The present invention aims at providing an Al connection material that may suppress generation of an internal crack at the time of manufacture and exhibits excellent temperature cycle reliability.

**MEANS FOR SOLVING PROBLEM**

As a result of earnest investigation as to the problem described above, the present inventors have found that the problem described above can be solved by an Al connection material containing 3.0% by mass or more and 12.0% by mass or less of Si, and containing 5 mass ppm or more and 800 mass ppm or less of one or more of Sr, Na, Eu, and Ca in total, and further investigated the problem based on such knowledge to complete the present invention.
That is, the present invention includes the following content.

<1> An Al connection material containing:

3.0% by mass or more and 12.0% by mass or less of Si; and
5 mass ppm or more and 800 mass ppm or less of one or more of Sr, Na, Eu, and Ca in total.

<2> The Al connection material according to <1>, wherein, when a crystal orientation of a Si phase in an L cross-section (cross section in a center axis direction including a center axis) of the Al connection material is measured, a total of orientation ratios of a <111> crystal orientation and a <110> crystal orientation angled at 15° or less to the center axis direction is equal to or larger than 20% and equal to or smaller than 70%.
<3> The Al connection material according to <1> or <2>, wherein an average diameter of a Si phase in the L cross-section is equal to or larger than 0.8 $\mu$m and equal to or smaller than 4 $\mu$m.
<4> The Al connection material according to any one of <1> to <3>, further containing 10 mass ppm or more and 500 mass ppm or less of one or more of Ti, B, and Zr in total.
<5> The Al connection material according to any one of <1> to <4>, further containing 5 mass ppm or more and 500 mass ppm or less of one or more of Ni, Y, Yb, and Sc in total.

**EFFECT OF THE INVENTION**

The present invention can provide an Al connection material that may suppress generation of an internal crack at the time of manufacture and exhibits excellent temperature cycle reliability.

**BRIEF DESCRIPTION OF DRAWINGS**

FIG. 1 is a schematic diagram for explaining a measurement target surface (inspection surface) at the time of measuring a crystal orientation and an average diameter of a Si phase for an Al connection material. The measurement target surface is a cross section in a center axis direction including a center axis (L cross-section) of the Al connection material.
FIG. 2 is a schematic diagram for explaining a hollow defect of a 1st bonding part.
FIG. 3 is an example of an internal crack of the Al connection material observed by a soft X-ray transmission device.

**EMBODIMENT FOR CARRYING OUT THE INVENTION**

Hereinafter, the present invention will be described in detail with reference to preferable embodiments thereof. While the drawings may be referred to for description, each of the drawings merely schematically illustrates shapes, sizes, and arrangement of constituent elements to the extent that the invention can be understood. The present invention is not limited to the following embodiments and examples, and may be optionally changed to be implemented without departing from CLAIMS of the present invention and equivalents thereof.

[Al connection material]

An Al connection material according to the present invention contains 3.0% by mass or more and 12.0% by mass or less of Si, and contains 5 mass ppm or more and 800 mass ppm or less of one or more of Sr, Na, Eu, and Ca in total.
As described above, in a case of using a connection material composed only of high-purity Al in a temperature cycle test (TCT), a crack develops at a relatively high speed inside the connection material, and it has been difficult to obtain favorable temperature cycle reliability. On the other hand, in a case of using an Al connection material that is highly strengthened by adding Si and the like thereto, a crack develops in an Al alloy electrode having relatively low strength, so that it has been confirmed that it is difficult to obtain temperature cycle reliability required for a next-generation power semiconductor device. Furthermore, regarding the Al connection material that is highly strengthened by adding Si and the like thereto, an internal crack may be generated at the time of manufacture thereof.
As a result of earnest investigation to solve the problem described above, the present inventors have found that, with the Al connection material containing 3.0% by mass or more and 12.0% by mass or less of Si, and containing 5 mass ppm or more and 800 mass ppm or less of one or more of Sr, Na, Eu, and Ca in total, generation of an internal crack may be suppressed at the time of manufacture thereof, and excellent temperature cycle reliability is exhibited. The Al connection material according to the present invention significantly contributes to achieving temperature cycle reliability required for the next-generation power semiconductor device.
The Al connection material according to the present invention contains 3.0% by mass or more and 12.0% by mass or less of Si and constitutes of an Al phase in which Si is dissolved in Al as a solid solution and a Si phase formed by crystallization or precipitation of Si. In the Al phase, other additive elements may be dissolved as a solid solution in addition to Si. The Si phase is a general term for Si crystallized products and Si precipitates. The Si crystallized product is formed from a solution during solidification, and has a size of about 1 to 20 $\mu$m, which is coarse. On the other hand, the Si precipitate is formed from a solid state, and has a small size of about 0.1 $\mu$m to several micrometers.
The reason why the Al connection material according to the present invention may suppress generation of an internal crack at the time of manufacture and can exhibit excellent temperature cycle reliability is estimated as follows.
Regarding the temperature cycle reliability, a coefficient of linear thermal expansion of the Si phase is smaller than that of Al, so that it is considered that the Si phase may contribute to reduction of a difference in the coefficient of linear thermal expansion between the Al connection material and a semiconductor chip and may further reduce generated thermal stress, and the particulate Si phase may suppress growth of a crack generated at a bonding interface to the inside of the Al connection material.
Regarding the internal crack, it is considered that lowering of adhesion to the Al phase or exfoliation from the Al phase may be caused on a surface of the Si phase constituted of coarse Si crystallized products, which may become a starting point of the crack. From this viewpoint, it is considered that an effect of improving adhesion at an interface between the Si phase and the Al phase can be obtained and generation of an internal crack can be suppressed when the Al connection material contains a high concentration of Si and contains a predetermined amount of one or more of Sr, Na, Eu, and Ca (hereinafter, also referred to as a "first element group"). This may be because part of the first element group is concentrated on the surface of the Si phase to improve the adhesion, or a shape of the Si phase becomes close to a granular shape or a spherical shape due to addition of the first element group to improve the adhesion.

As described above, it can be estimated that, as a result of appropriate control of factors contributing to suppression of internal cracks and improvement of the temperature cycle reliability, the Al connection material according to the present invention may suppress generation of internal cracks at the time of manufacture, and can exhibit excellent temperature cycle reliability as described above.

-Si concentration-

A Si concentration in a range equal to or larger than 3.0% by mass and equal to or smaller than 12.0% by mass is useful in reducing thermal distortion of a bonding part and improving a temperature cycle characteristic. If the Si concentration is smaller than 3.0% by mass, an improvement effect is small. If the Si concentration exceeds 12.0% by mass, there are problems such as lowering of initial bonding strength due to hardening, or damage to the semiconductor chip. From a viewpoint of obtaining favorable temperature cycle reliability, the concentration of Si in the Al connection material according to the present invention is equal to or larger than 3.0% by mass, preferably equal to or larger than 3.5% by mass, more preferably equal to or larger than 3.6% by mass, equal to or larger than 3.8% by mass, equal to or larger than 4.0% by mass, equal to or larger than 4.2% by mass, equal to or larger than 4.4% by mass, equal to or larger than 4.5% by mass, equal to or larger than 4.6% by mass, equal to or larger than 4.8% by mass, or equal to or larger than 5.0% by mass. On the other hand, if hardness of the Al connection material becomes excessive, the semiconductor chip tends to be easily damaged at the time of 1st bonding under a bonding condition with ultrasonic vibrations and loads that are generally used. From a viewpoint of obtaining favorable bonding strength in a case of performing 1st bonding under a general bonding condition, the Si concentration in the Al connection material according to the present invention is equal to or smaller than 12.0% by mass, preferably equal to or smaller than 11.5% by mass or equal to or smaller than 11.0% by mass, more preferably equal to or smaller than 10.8% by mass, equal to or smaller than 10.6% by mass, equal to or smaller than 10.5% by mass, equal to or smaller than 10.4% by mass, equal to or smaller than 10.2% by mass, or equal to or smaller than 10.0% by mass.

For concentration analysis of elements contained in the Al connection material according to the present invention, for example, an Inductively Coupled Plasma (ICP) emission spectrophotometer or an ICP mass spectrometer can be used. In a case in which elements derived from contaminants in the air, such as oxygen or carbon, are adsorbed on a surface of the Al connection material, it is effective to clean it with acid or alkali depending on adsorbed substances before performing analysis.

-Concentration of first element group-

From a viewpoint of suppressing generation of internal cracks at the time of manufacture and obtaining favorable temperature cycle reliability, a total concentration of the first element group in the Al connection material according to the present invention is equal to or larger than 5 mass ppm, preferably equal to or larger than 10 mass ppm, more preferably equal to or larger than 20 mass ppm, equal to or larger than 30 mass ppm, equal to or larger than 40 mass ppm, or equal to or larger than 50 mass ppm, even more preferably equal to or larger than 60 mass ppm, equal to or larger than 80 mass ppm, or equal to or larger than 100 mass ppm, and an upper limit thereof is equal to or smaller than 800 mass ppm, preferably equal to or smaller than 750 mass ppm or equal to or smaller than 700 mass ppm, more preferably equal to or smaller than 650 mass ppm or equal to or smaller than 600 mass ppm, and even more preferably equal to or smaller than 580 mass ppm, equal to or smaller than 560 mass ppm, or equal to or smaller than 550 mass ppm. The total concentration of the first element group falling within the preferred range described above is also advantageous from a viewpoint of easily achieving favorable 1st bonding strength while suppressing damage to the semiconductor chip.

-Crystal orientation of Si phase in L cross-section-

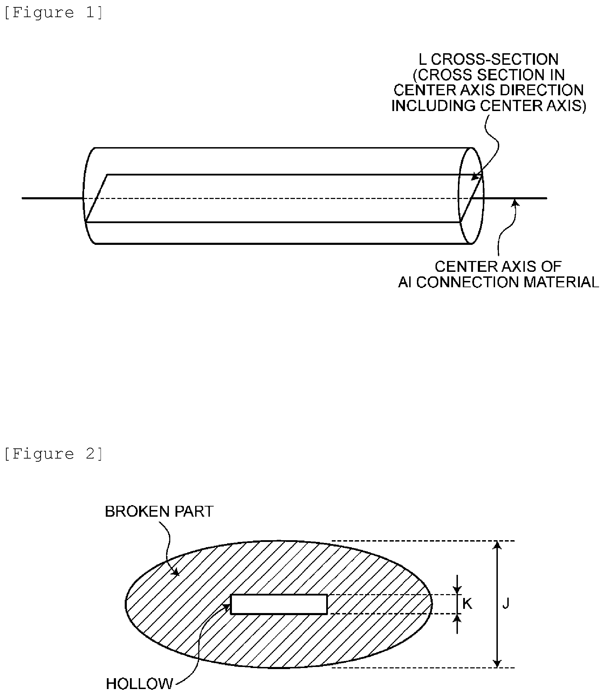

From a viewpoint of obtaining more favorable temperature cycle reliability, and a viewpoint of reducing a generation frequency of wire breakage in wire-drawing processing, when a crystal orientation of the Si phase in an L cross-section of the Al connection material is measured, a total of orientation ratios of a <111> crystal orientation and a <110> crystal orientation angled at 15° or less to a center axis direction (hereinafter, also referred to as "<111> + <110> total ratio of the Si phase") preferably falls within a range equal to or larger than 20% and equal to or smaller than 70%. In the present invention, the L cross-section of the Al connection material, that is, a cross section in the center axis direction including the center axis of the Al connection material, will be described later in "(Method for measuring crystal orientation of Si phase)" with reference to FIG. 1.

In addition to control of the Al alloy composition described above, by setting the <111> + <110> total ratio of the Si phase to fall within such a range, effects of extending the number of times of tests until a fault of lowering the bonding strength occurs, and adapting to expansion of a temperature difference in the temperature cycle test, and the like can be obtained, so that more favorable temperature cycle reliability can be achieved. This may be because, when the <111> crystal orientation and the <110> crystal orientation of the Si phase are aligned, working of improving adhesion at the interface between the Si phase and the Al phase, working of reducing deformation of the Al connection material in the center axis direction, and the like are obtained, so that an effect of suppressing a fault such as crack development at the bonding part caused by thermal distortion in the temperature cycle test is exhibited. In an Al alloy containing a high concentration of Si equal to or larger than 3.0% by mass and equal to or smaller than 12.0% by mass, a frequency of wire breakage at a wire-drawing step tends to be increased. This may be because particles of the Si phase crystallized at the time of solidification cause stress concentration during the wire-drawing processing, and induce wire breakage. From this viewpoint, when the Al connection material contains a predetermined amount of the first element group and the <111> + <110> total ratio of the Si phase is adjusted to fall within the preferred range described above, it is estimated that wire breakage can be reduced due to working of relieving stress concentration during wire-drawing and the like. From a viewpoint of obtaining more excellent temperature cycle reliability and reducing a generation frequency of wire breakage in the wire-drawing processing, the <111> + <110> total ratio of the Si phase is more preferably equal to or larger than 25%, even more preferably equal to or larger than 26%, equal to or larger than 28%, or equal to or larger than 30%, and an upper limit thereof is more preferably equal to or smaller than 65%, and even more preferably equal to or smaller than 60%, equal to or smaller than 58%, equal to or smaller than 56%, equal to or smaller than 55%, equal to or smaller than 54%, equal to or smaller than 52%, or equal to or smaller than 50%.

In measuring the <111> + <110> total ratio of the Si phase in the L cross-section of the Al connection material, a method of combining information of Al concentration and Si concentration obtained by SEM-EDS and information of a crystal orientation obtained by Electron BackScatter Diffraction (EBSD) can be used. Specifically, in a measurement region assuming that the L cross-section of the Al connection material is an inspection surface, measurement of concentration of Al and Si using the EDS and crystal orientation analysis using the EBSD are performed at the same time. Subsequently, the Al phase and the Si phase are separated and extracted from a measurement result of the EDS by using analysis software attached to the device. Specifically, it is preferable to use Chi Scan function, which is a function of analysis software OIM Data Collection or OIM Analysis (both manufactured by TSL solutions KK) attached to an FE-SEM device. Subsequently, for a region that is specified as the Si phase, the orientation ratios of the <111> crystal orientation and the <110> crystal orientation of the Si phase can be calculated by using the analysis software attached to the device. In calculating the orientation ratio, a partial ratio is used, which is calculated assuming that an area of only the crystal orientation identified based on certain reliability is a population in a measurement area. Thus, in one embodiment, the orientation ratio of the crystal orientation of the Si phase in the L cross-section of the Al connection material according to the present invention is calculated through procedures from (1) to (3) as follows.

(1) In the measurement region designating the L cross-section of the Al connection material to be the inspection surface, measurement of concentration of Al and Si using the EDS and crystal orientation measurement using the EBSD are performed at the same time.
(2) Al and Si are separated and extracted by using the Chi Scan function. Specifically, Al and Si can be separated and identified by setting Tolerance corresponding to a threshold of Si based on a measurement result of the EDS for Si. The crystal orientation can be analyzed by using the crystal information of Al and Si from a material file.
(3) For the region that is specified as the Si phase, the crystal orientation is analyzed, and the orientation ratio of the <111> crystal orientation and the orientation ratio of the <110> crystal orientation of the Si phase are calculated.

In the procedure of (2) described above, setting of Tolerance (%) can be selected from a range from 20 to 40%, and about 30% is preferable for comparison in standard analysis of the L cross-section of the Al connection material. The following supplementarily describes a procedure of adjusting the Tolerance. It is preferable to select or confirm a numerical value of Tolerance so that the shape and the size of the Si phase extracted and identified by the Chi Scan function are equivalent to the shape and the size of the Si phase identified from an EDS map in which Si element concentration by EDS analysis is two-dimensionally displayed.

In the present invention, each of the orientation ratio of the <111> crystal orientation and the orientation ratio of the <110> crystal orientation of the Si phase in the L cross-section was calculated as an average value of respective values obtained by measuring three or more parts. In selecting the measurement region, from a viewpoint of securing objectivity of measurement data, it is preferable to acquire a sample for measurement to be measured from the Al connection material as a measurement target at intervals of 50 cm or more with respect to the center axis direction of the Al connection material. In the present invention, the measurement region for the crystal orientation measured by the EBSD method is preferably determined so that the length in the center axis direction of the Al connection material is equal to or larger than 300 $\mu$m and smaller than 800 $\mu$m, and the entire Al connection material is accommodated therein in the direction perpendicular to the center axis of the Al connection material, but if the size is large and the entire region is difficult to be measured, it may be adjusted in a range smaller than 600 $\mu$m.

-Average diameter of Si phase in L cross-section-

In the Al connection material according to the present invention, an average diameter of the Si phase in the L cross-section is preferably equal to or larger than 0.8 $\mu$m and equal to or smaller than 4 $\mu$m.

Regarding the Al connection material that is highly strengthened by adding Si and the like thereto, the semiconductor chip tends to be damaged at the time of 1st bonding, and if ultrasonic vibrations and loads are adjusted to reduce such damage, a phenomenon in which a part with insufficient metallic bonding is formed in the vicinity of the center of a bonding region of the Al connection material and the electrode (hereinafter, also referred to as a "hollow") may be caused. The portion where the hollow is generated becomes a starting point where bonding strength is lowered or a fault is caused in a temperature cycle test because metallic bonding is insufficient.

When the average diameter of the Si phase in the L cross-section falls within a range equal to or larger than 0.8 $\mu$m and equal to or smaller than 4 $\mu$m, a hollow at a 1st bonding part can be suppressed. It is considered that an effect of accelerating deformation of the Al phase contributing to bonding, or enhancing transmission efficiency of ultrasonic vibrations to a center part of the bonding region is obtained by controlling the average diameter of the Si phase, and the hollow can be suppressed.

From a viewpoint of further suppressing a hollow at the 1st bonding part, the average diameter of the Si phase in the L cross-section of the Al connection material according to the present invention is more preferably equal to or smaller than 3.5 $\mu$m, even more preferably equal to or smaller than 3.4 $\mu$m, equal to or smaller than 3.2 $\mu$m, or equal to or smaller than 3 $\mu$m, and a lower limit thereof is more preferably equal to or larger than 1 $\mu$m, and even more preferably equal to or larger than 1.2 $\mu$m.

The following describes a method for measuring the average diameter of the Si phase in the L cross-section of the Al connection material. In measuring the average diameter of the Si phase in the L cross-section, similarly to measurement of the <111> + <110> total ratio of the Si phase described above, a method of combining information of Al concentration and Si concentration obtained by the SEM-EDS and information of crystal orientation obtained by the EBSD can be used. A specific procedure is the same as that described above in relation to measurement of the <111> + <110> total ratio of the Si phase, that is, the crystal orientation can be analyzed for a region specified as the Si phase by using the analysis software attached to the device. If an orientation difference between measurement points is equal to or larger than 15°, it is determined to be a crystal grain boundary, and an equivalent circle diameter is calculated. An average value of equivalent circle diameters of respective Si phases is defined as the average diameter of the Si phase. In a process of obtaining the average diameter of the Si phase, calculation is performed excluding a part in which the crystal orientation cannot be measured, and a part in which the crystal orientation can be measured but reliability of orientation analysis is low. Thus, in one embodiment, the average diameter of the Si phase in the L cross-section of the Al connection material according to the present invention is calculated through procedures from (1) to (3) as follows.

(1) The L cross-section of the Al connection material is designated as the inspection surface, and measurement of concentration of Al and Si using the EDS and crystal orientation measurement using the EBSD are performed at the same time.

(2) Al and Si are separated and extracted by using the Chi Scan function. Specifically, Al and Si can be separated and identified by setting Tolerance corresponding to a threshold of Si based on a measurement result of the EDS for Si. The crystal orientation can be analyzed by using the crystal information of Al and Si from the material file.

(3) For the region that is specified as the Si phase, the crystal orientation is analyzed, and if the orientation difference between measurement points is equal to or larger than 15°, it is determined to be the crystal grain boundary, and the equivalent circle diameter of each crystal grain is obtained. An average of equivalent circle diameters of the respective crystal grains is calculated to obtain the average diameter of the Si phase. Herein, regarding average calculation, an average value obtained by Area average, which can be selected by the software attached to the device, is employed. By employing the average value obtained by Area average, it is possible to accurately measure and determine whether a condition is met, the condition being related to the average diameter of the Si phase that is suitable for suppressing a hollow at the 1st bonding part. In the calculation of Area average, the average value is calculated from an average of values obtained by multiplying a ratio of an area of each particle to areas of all particles by an area value of each particle, which is automatically computed by software.

In the present invention, in calculating the average diameter of the Si phase in the L cross-section, only Si phases having a diameter (equivalent circle diameter) equal to or larger than 0.5 $\mu$m are considered as targets. Due to this, it is possible to accurately determine whether a requirement is met, the requirement being related to the average diameter of the Si phase in the L cross-section that is suitable for suppressing a hollow at the 1st bonding part.

In measuring the average diameter of the Si phase in the L cross-section, a setting range of Tolerance in the procedure of (2) described above, a method of acquiring a sample for measurement, and a measurement region of the crystal orientation by the EBSD method are the same as those described above regarding measurement of the <111> + <110> total ratio of the Si phase.

Examples of the method for measuring the average diameter of the Si phase include several methods including binarization processing from an observation image of the L cross-section in addition to the methods described above. The present invention uses the method of combining information of Al concentration and Si concentration obtained by the SEM-EDS and information of crystal orientation obtained by the EBSD as described above because many measuring functions are provided and a plurality of characteristics such as the <111> + <110> total ratio of the Si phase and the average diameter of the Si phase described above can be obtained by one time of measurement, automatic analysis can be performed, and measurement can be easily performed with a widespread device and analysis technique.

-Average diameter of Al phase in L cross-section-

In the Al connection material according to the present invention, an average diameter of the Al phase in the L cross-section is preferably equal to or larger than 5 $\mu$m and equal to or smaller than 40 $\mu$m.

When the average diameter of the Al phase in the L cross-section falls within the range equal to or larger than 5 $\mu$m and equal to or smaller than 40 $\mu$m, a high effect of reducing variations in bonding strength in 2nd bonding is obtained. That is, this is considered to be a synergistic effect of containing the predetermined concentration of Si and containing a predetermined amount of one or more of Sr, Na, Eu, and Ca as the first element group to accelerate deformation of the Al connection material by ultrasonic vibrations, and uniformizing deformation of the Al connection material in both directions parallel with and perpendicular to the center axis of the Al connection material by setting the average diameter of the Al phase to be equal to or larger than 5 $\mu$m and equal to or smaller than 40 $\mu$m.

In measuring the average diameter of the Al phase in the L cross-section of the Al connection material, similarly to measurement of the average diameter of the Si phase, a method of combining information of Al concentration and Si concentration obtained by the SEM-EDS and information of crystal orientation obtained by the EBSD can be used. Thus, in one embodiment, the average diameter of the Al phase in the L cross-section of the Al connection material according to the present invention is calculated through the procedure (3) as follows after the procedures (1) and (2) described above are performed. (3) For the region that is specified as the Al phase, the crystal orientation is analyzed, and if the orientation difference between measurement points is equal to or larger than 15°, it is determined to be the crystal grain boundary, and the equivalent circle diameter of each crystal grain is obtained. An average of equivalent circle diameters of the respective crystal grains is calculated to obtain the average diameter of the Al phase. Regarding average calculation, similarly to the measurement of the average diameter of the Si phase, an average value obtained by Area average, which can be selected by the software attached to the device, is employed.

In calculating the average diameter of the Al phase in the L cross-section, only Al phases having a diameter (equivalent circle diameter) equal to or larger than 0.5 $\mu$m are considered as targets. In measuring the average diameter of the Al phase in the L cross-section, a setting range of Tolerance in the procedure of (2) described above, a method of acquiring a sample for measurement, and a measurement region of the crystal orientation by the EBSD method are the same as those described above regarding measurement of the <111> + <110> total ratio of the Si phase.

-Addition of Ti, B, and Zr-

The Al connection material according to the present invention may further contain 10 mass ppm or more and 500 mass ppm or less of one or more of Ti, B, and Zr (hereinafter, also referred to as a "second element group") in total.

In a case of bonding the Al connection material by applying ultrasonic vibrations and loads, it is important to manage a bonding shape thereof. The bonding shape of the Al connection material can be evaluated by an impression length (hereinafter, referred to as a "bonding length") in the center axis direction of the Al connection material at an impression of a broken part when a shear force test for the bonding part is performed. Reducing and stabilizing variations in the bonding length contributes to improvement of the temperature cycle reliability. From this viewpoint, it is effective that the Al connection material that is highly strengthened by adding Si and the like thereto is bonded under a condition with a large ultrasonic output at an initial stage of a bonding time to enhance bondability. However, under such a bonding condition, strong ultrasonic vibrations are applied at an initial stage of deformation, so that there is concern that sliding between a bonding tool and the Al connection material may be unstable, and variations in the bonding length may be increased.

In a process of investigating the Al connection material containing 3.0% by mass or more and 12.0% by mass or less of Si and containing a predetermined amount of the first element group, the present inventors have found that, when the Al connection material further contains 10 mass ppm or more and 500 mass ppm or less of the second element group in total, variations in the bonding length of the Al connection material can be reduced at the time of bonding the Al connection material by applying ultrasonic vibrations and loads. When the second element group is concentrated on the surface of the Al connection material, or affects an oxide film on the surface of the Al connection material, it is considered that working of controlling friction, a crystal structure, hardness, and the like on the surface of the Al connection material is exhibited.

From a viewpoint of reducing variations in the bonding length at the time of bonding, and achieving the temperature cycle reliability required for the next-generation power semiconductor device more favorably, a total concentration of the second element group in the Al connection material according to the present invention is more preferably equal to or larger than 20 mass ppm, even more preferably equal to or larger than 30 mass ppm, equal to or larger than 40 mass ppm, or equal to or larger than 50 mass ppm, and an upper limit thereof is, from a viewpoint of suppressing damage to the semiconductor chip and easily achieving favorable 1st bonding strength, preferably equal to or smaller than 450 mass ppm, and more preferably equal to or smaller than 440 mass ppm, equal to or smaller than 420 mass ppm, or equal to or smaller than 400 mass ppm.

-Addition of Ni, Y, Yb, and Sc-

The Al connection material according to the present invention may further contain 5 mass ppm or more and 500 mass ppm or less of one or more of Ni, Y, Yb, and Sc (hereinafter, also referred to as a "third element group") in total.

By further containing 5 mass ppm or more and 500 mass ppm or less of one or more of Ni, Y, Yb, and Sc in total, generation of scratches and scrapes on the surface of the Al connection material can be suppressed, and a smooth surface can be formed. In an Al alloy containing a high concentration of Si equal to or larger than 3.0% by mass and equal to or smaller than 12.0% by mass, scratches and/or scrapes may be generated on a surface thereof during the wire-drawing processing, and may results in the Al connection material with large surface unevenness when the surface is hardened or the Si phase and Al oxide present on the surface are dropped. It is estimated that scratches and scrapes during the wire-drawing processing can be reduced by adding the third element group to accelerate stabilization of the Al oxide on the surface of the Al connection material, reduction of friction between the Al connection material and a die, and the like. It is considered that an effect of suppressing generation of scratches and scrapes on the surface of the Al connection material to form a smooth surface can be enhanced by adding the third element group in combination with the first element group.

From a viewpoint of suppressing generation of scratches and scrapes on the surface to form the Al connection material having a smooth surface, a total concentration of the third element group in the Al connection material according to the present invention is more preferably equal to or larger than 10 mass ppm, even more preferably equal to or larger than 20 mass ppm, equal to or larger than 30 mass ppm, equal to or larger than 40 mass ppm, or equal to or larger than 50 mass ppm, and an upper limit thereof is, from a viewpoint of suppressing damage to the semiconductor chip and easily achieving favorable 1st bonding strength, more preferably equal to or smaller than 450 mass ppm, and even more preferably equal to or smaller than 440 mass ppm, equal to or smaller than 420 mass ppm, or equal to or smaller than 400 mass ppm.

As an aluminum raw material for manufacturing the Al connection material according to the present invention, it is preferable to use Al having a purity of 4N (Al: 99.99% by mass or more), and more preferable to use Al having a purity of 5N (Al: 99.999% by mass or more) in which an amount of impurities is smaller.

In a range of not inhibiting the effect of the present invention, the Al connection material according to the present invention may further contain elements other than Al, Si, the first element group, the second element group, and the third element group (hereinafter, also referred to as "other elements"). A total concentration of the other elements in the Al connection material is not particularly limited in a range of not inhibiting the effect of the present invention. The total concentration of the other elements may be, for example, equal to or smaller than 0.5% by mass, equal to or smaller than 0.4% by mass, equal to or smaller than 0.3% by mass, equal to or smaller than 0.2% by mass, equal to or smaller than 0.15% by mass, equal to or smaller than 0.1% by mass, equal to or smaller than 0.08% by mass, equal to or smaller than 0.06% by mass, equal to or smaller than 0.05% by mass, equal to or smaller than 0.04% by mass, equal to or smaller than 0.03% by mass, equal to or smaller than 0.025% by mass, equal to or smaller than 0.02% by mass, equal to or smaller than 0.018% by mass, equal to or smaller than 0.016% by mass, equal to or smaller than 0.015% by mass, equal to or smaller than 0.014% by mass, equal to or smaller than 0.012% by mass, or equal to or smaller than 0.01% by mass. A lower limit of the total concentration of the other elements is not particularly limited, and may be 0% by mass.

According to one embodiment, a balance of the Al connection material according to the present invention consists of Al and inevitable impurities. Thus, according to a preferred embodiment, the Al connection material according to the present invention consists of Al, Si, one or more elements of the first element group, and inevitable impurities. According to another preferred embodiment, the Al connection material according to the present invention consists of Al, Si, one or more elements of the first element group, one or more elements of the second element group, and inevitable impurities. According to yet another preferred embodiment, the Al connection material according to the present invention consists of Al, Si, one or more elements of the first element group, one or more elements of the third element group, and inevitable impurities. According to yet another preferred embodiment, the Al connection material according to the present invention consists of Al, Si, one or more elements of the first element group, one or more elements of the second element group, one or more elements of the third element group, and inevitable impurities.

In a preferred embodiment, the Al connection material according to the present invention does not have a coating that contains a metal other than Al as a main component on an outer periphery of the Al connection material. Herein, the "coating that contains a metal other than Al as a main component" means the coating in which the content of the metal other than Al is 50% by mass or more.

The Al connection material according to the present invention may be an Al bonding wire or an Al bonding ribbon. In a case in which the Al connection material according to the present invention is the Al bonding wire, a wire diameter thereof is not particularly limited, and may fall within a range from 100 to 600 $\mu$m, for example. In a case in which the Al connection material according to the present invention is the Al bonding ribbon, dimensions (W$\times$T) of a cross section having a rectangular shape or a substantially rectangular shape are not particularly limited, for example, W may be 100 to 3000 $\mu$m and T may be 50 to 600 $\mu$m.

The Al connection material according to the present invention may suppress generation of internal cracks at the time of manufacture, and can exhibit excellent temperature cycle reliability. Accordingly, the Al connection material according to the present invention can be preferably used as an Al connection material for a semiconductor device, especially as an Al connection material for a power semiconductor device.

-Method for manufacturing Al connection material-

The following describes an example of a method for manufacturing the Al connection material according to the present invention. The following describes an example of manufacture of an Al bonding wire having a wire diameter of 200 to 400 $\mu$m.

Al and alloy elements as raw materials preferably have a high purity. Al preferably has a purity of 99.99% by mass or more and includes inevitable impurities as a balance. Si, the first element group, the second element group, and the third element group used as alloy elements preferably have a purity of 99.9% by mass or more and include inevitable impurities as a balance. An Al alloy used for the bonding wire can be manufactured by loading an Al raw material and raw materials for alloy elements into a crucible made of graphite or alumina that is processed to obtain an ingot having a cylindrical shape, and melting the raw materials by using an electric furnace or a highfrequency heating furnace. A diameter of the ingot having a cylindrical shape is preferably equal to or larger than $\Phi$6 mm and smaller than $\Phi$8 mm while considering processability in a subsequent processing step. An atmosphere in the furnace at the time of melting is preferably an inert atmosphere or a reducing atmosphere to prevent Al or other elements constituting the wire from being excessively oxidized. The highest end-point temperature of melted metal at the time of melting preferably falls within a range equal to or higher than 800°C and lower than 1050°C, considering to facilitate control of the shape and the size of the Si phase at the time of solidification and the like while securing fluidity of the melted metal. As a method for cooling after the melting, water cooling, furnace cooling, air cooling, and the like can be used.

By performing solution treatment to heat the ingot having a cylindrical shape obtained by melting at a high temperature, and repeatedly performing wire-drawing processing using dies thereon, the wire having a desired wire diameter can be manufactured. The wire after being subjected to the wire-drawing processing can be used as an Al alloy bonding wire by performing final heat treatment using the electric furnace.

To control the crystal orientation and the particle diameter of the Si phase in the L cross-section, it is effective to control a heat treatment condition for solution treatment, homogenization processing, or final heat treatment, a wire-drawing processing condition, and the like. At the time of wire-drawing processing, it is effective to use a lubricating liquid to secure lubricity at a contact interface between the wire and the die.

For the Al connection material according to the present invention containing the first element group (Sr, Na, Eu, Ca), the particle diameter of the Si phase tends to be easily controlled. The first element group affects a form of the Si phase, so that an appropriate range of a manufacturing condition may be different depending on a type or concentration of the first element group.

The following describes an example of the manufacturing condition for controlling the <111> + <110> total ratio of the Si phase in the L cross-section to fall within a range equal to or larger than 20% and equal to or smaller than 70%.

To adjust the crystal orientation of the Si phase, it is effective to perform heat treatment in two stages on the ingot, and control an area reduction ratio in the wire-drawing processing.

It is effective to set a temperature range for the solution treatment to be equal to or higher than 400°C and lower than 550°C, and set a time therefor to be equal to or longer than 1 hour and shorter than 6 hours. After the solution treatment, it is effective to perform homogenization processing at a temperature equal to or higher than 250°C and lower than 350°C for a time equal to or longer than 2 hours and shorter than 10 hours. Due to this, fragmentation and growth of the Si phase crystallized in a solidification process are accelerated, so that alignment of <111> and <110> can be accelerated regarding the crystal orientation of the Si phase.

Regarding the wire-drawing processing condition, it is effective to set an area reduction ratio of the wire per die used at the time of wire-drawing processing to fall within a range equal to or larger than 10% and smaller than 30%. Herein, defining that the area reduction ratio of the wire per die is P1, P1 is represented by the following expression.

$$P1 = \{(R_2^2 - R_1^2)/R_2^2\} \times 100$$

In the expression, $R_2$ represents a diameter (mm) of the wire before processing, and $R_1$ represents a diameter (mm) of the wire after processing.

By adjusting the area reduction ratio of the wire in the higher range (higher area reduction ratio) described above than a normal wire-drawing processing condition, the entire wire can be largely deformed at the time of die processing, processing distortion is increased to the inside of the wire, and the Si phase is arranged in the wire center axis direction while processing distortion in the Si phase is adjusted. From such a state of the wire-drawing processing, by performing heat treatment thereafter, the orientation ratios of the <111> crystal orientation and the <110> crystal orientation with high atomic density can be increased.

To adjust the average diameter of the Si phase in the L cross-section to fall within a range equal to or larger than 0.8 $\mu$m and equal to or smaller than 4 $\mu$m, it is effective to adjust a temperature at the time of melting in a range equal to or higher than 800°C and lower than 1000°C and adjust a casting temperature in a range equal to or higher than 700°C and lower than 780°C, and to control a temperature for the solution treatment in a range equal to or higher than 400°C and lower than 550°C and control a time for the solution treatment in a range equal to or longer than 1 hour and shorter than 6 hours. The casting temperature is a temperature at the time of casting a melted liquid into a mold and the like, and corresponds to a solidification starting temperature. When the casting temperature is high, the Si phase crystallized at the time of solidification tends to be coarsened and columnarized, and the average diameter of the Si phase tends to be increased. When the temperature for the solution treatment is high, the columnar Si phase is fragmented and granulated, and the average diameter of the Si phase tends to be reduced. To further reduce the average diameter of the Si phase, it is effective to increase a cooling speed at the time of solidification, for example, to perform water cooling.

To control the average diameter of the Al phase in the L cross-section to fall within a range equal to or larger than 5 $\mu$m and equal to or smaller than 40 $\mu$m, it is effective to adjust a temperature and a time for heat treatment at the final wire diameter, and control growth of the crystal grains due to recrystallization of the Al phase.

As a representative example of the Al connection material, the example of manufacture of the Al bonding wire as a wire material has been described above. The Al bonding ribbon as a bar material can also be manufactured basically through the same procedure. As the temperature and the time for the heat treatment, substantially the same conditions as described above can be used. In a case of manufacturing the Al bonding ribbon by rolling processing, an area reduction ratio of a die may be replaced with a rolling reduction ratio to be adjusted.

[Semiconductor device]

The semiconductor device can be manufactured by connecting the electrode on the semiconductor chip to the lead frame or an external electrode on the substrate by using the Al connection material according to the present invention. As described above, wedge bonding is used for both of the 1st bonding with the electrode on the semiconductor chip and the 2nd bonding with the lead frame or the electrode on the substrate.

In one embodiment, the semiconductor device according to the present invention includes a circuit board, the semiconductor chip, and the Al connection material for bringing the circuit board and the semiconductor chip into conduction with each other, and is characterized in that the Al connection material is the Al connection material according to the present invention.

In the semiconductor device according to the present invention, the circuit board and the semiconductor chip are not particularly limited, and a known circuit board and semiconductor chip that may be used for constituting the semiconductor device may be used. Alternatively, a lead frame may be used in place of the circuit board. For example, like the semiconductor device disclosed in Japanese Patent Application Laid-open No. 2020-150116, the semiconductor device may include a lead frame and a semiconductor chip mounted on the lead frame.

Examples of the semiconductor device include various semiconductor devices used for electric products (for example, a computer, a cellular telephone, a digital camera, a television, an air conditioner, a solar power generation system), vehicles (for example, a motorcycle, an automobile, an electric train, a ship, and an aircraft), and the like, and a semiconductor device for electric power (power semiconductor device) is especially preferred.

[Examples]

Hereinafter, the present invention will be described in detail with reference to Examples. However, the present invention is not limited to the following Examples.

(Sample)

A method for producing a sample will be described. As a raw material, Al having a purity of 4N (99.99% by mass or more) and including inevitable impurities as a balance was used. Si, the first element group (Sr, Na, Eu, Ca), the second element group (Ti, B, Zr), and the third element group (Ni, Y, Yb, Sc) used as alloy elements each having a purity of 99.99% by mass or more and including inevitable impurities as a balance were used. The Al alloy used for the Al connection material was manufactured by loading an Al raw material and raw materials for the alloy elements into an alumina crucible, and melting them by using a highfrequency heating furnace. An atmosphere inside the furnace at the time of melting was an Ar atmosphere, the highest end-point temperature of melted metal at the time of melting was set to be equal to or higher than 800°C and lower than 1000°C, and the casting temperature was set to be equal to or higher than 700°C and lower than 780°C. The cooling method after the melting was air cooling for performing cooling in the air, or water cooling for performing cooling in water.

After an ingot of $\Phi6$ mm having a cylindrical shape was obtained by melting, and the ingot was subjected to solution treatment and homogenization processing, wire-drawing processing using dies and intermediate heat treatment were performed to produce an Al connection material (Al bonding wire) of $\Phi300$ $\mu$m. A temperature range for the solution treatment was set to be equal to or higher than 400°C and lower than 550°C, and a time therefor was set to be equal to or longer than 1 hour and shorter than 4 hours. Homogenization processing was successively performed in the intermediate of cooling after the solution treatment was ended. A temperature range for the homogenization processing was set to be equal to or higher than 250°C and lower than 350°C, and a time therefor was set to be equal to or longer than 4 hours and shorter than 10 hours. The cooling method after the homogenization processing was air cooling for performing cooling in the air.

A commercially available lubricating liquid was used at the time of the wire-drawing processing, and an area reduction ratio of the wire per die at the time of the wire-drawing processing was equal to or larger than 14% and smaller than 30%. A temperature range for the final heat treatment was set to be equal to or higher than 250°C and lower than 350°C, and a time for the final heat treatment was set to be equal to or longer than 4 hours and shorter than 18 hours.

(Method for measuring element content)

For concentration analysis of elements contained in the Al connection material, ICP-OES ("PS3520UVDDII" manufactured by Hitachi High-Tech Science Corporation) or ICP-MS ("Agilent 7700x ICP-MS" manufactured by Agilent Technologies, Inc.) was used as an analysis device.

(Method for measuring crystal orientation of Si phase)

The L cross-section (cross section in the center axis direction including the center axis) of the Al connection material was designated as the inspection surface, and the crystal orientation of the Si phase was measured. In the present invention, the center axis of the Al connection material, and the cross section in the center axis direction including the center axis (L cross-section) are illustrated in FIG. 1. FIG. 1 illustrates a case in which the Al connection material is an Al bonding wire having a circular cross-sectional shape. In a case in which the Al connection material is an Al bonding ribbon having a rectangular or substantially rectangular cross-sectional shape with a width W and a thickness T, the center axis indicates an axis passing through the center of the width W and the center of the thickness T, and the L cross-section indicates a cross section in the center axis direction including the center axis and in a direction of the thickness T. At the time of processing the cross section to expose the L cross-section of the Al connection material, the cross section may be deviated from the center axis of the Al connection material. At this point, if the length of the L cross-section in the direction perpendicular to the center axis is 90% or more of the wire diameter of the Al connection material (or the thickness T in a case of the ribbon), the cross-section can be regarded as a cross section including the center axis.

An FE-SEM (SU-70 manufactured by Hitachi High-Tech Corporation) was used for measurement, and APEX (for data collection) manufactured by TSL solutions KK, OIM Data Collection (for Chi Scan), and OIM Analysis (for data analysis) were used as analysis software. Measurement regions at three parts were randomly selected at intervals of 50 cm or more with respect to the center axis direction of the Al connection material, and the regions at the three parts were measured. The measurement region was determined so that the length in the center axis direction of the Al connection material was equal to or larger than 300 $\mu$m and smaller than 800 $\mu$m, and the entire Al connection material was accommodated in the direction perpendicular to the center axis. As a main condition for EDS and EBSD measurement, an acceleration voltage was set to be 15 kV, a measurement magnification was set to be 350-fold, a scan speed was set to be 30 to 120 points/second, and a measurement interval was set to fall within a range from 0.1 to 0.3 $\mu$m. Herein, if the scan speed is high, the measurement time can be shortened, but there is concern that measurement accuracy of the EDS may be lowered. It is preferable to select an appropriate scan speed in the range described above.

In measuring the orientation ratio of the crystal orientation of the Si phase in the L cross-section of the Al connection material, a method of combining information of Al concentration and Si concentration obtained by the SEM-EDS and information of a crystal orientation obtained by the EBSD was used. Specifically, measurement was performed in accordance with procedures from (1) to (3) as follows.

(1) In the measurement region designating the L cross-section of the Al connection material to be the inspection surface, measurement of concentration of Al and Si using the EDS and crystal orientation measurement using the EBSD were performed at the same time.

(2) Al and Si were separated and extracted by using the Chi Scan function as a function of EBSD analysis software. Specifically, Al and Si were separated and identified by setting Tolerance corresponding to a threshold of Si based on a measurement result of the EDS for Si. The crystal information of Al and Si from the material file was used for analyzing the crystal orientation. Herein, a condition for Tolerance is mainly set to be 30%, and can be adjusted as needed.

(3) For the region that was specified as the Si phase, the crystal orientation was analyzed, and the orientation ratio of the <111> crystal orientation and the orientation ratio of the <110> crystal orientation of the Si phase were calculated. For the orientation ratio of the crystal orientation, a partial ratio was used.

Each of the orientation ratio of the <111> crystal orientation and the orientation ratio of the <110> crystal orientation of the Si phase was calculated as an average value of respective values obtained for measurement regions at three parts through the procedures from (1) to (3) described above.

(Method for measuring average diameter of Si phase)

In measuring the average diameter of the Si phase in the L cross-section of the Al connection material, similarly to the measurement of the crystal orientation of the Si phase, a method of combining information of Al concentration and Si concentration obtained by the SEM-EDS and information of the crystal orientation obtained by the EBSD was used. Specifically, after performing the procedures (1) and (2) described above, measurement was performed through the procedure (3) as follows. (3) For the region that is specified as the Si phase, the crystal orientation was analyzed, and if the orientation difference between measurement points was equal to or larger than 15°, it was determined to be the crystal grain boundary, and the equivalent circle diameter of each crystal grain was obtained. An average of equivalent circle diameters of the respective crystal grains was calculated to obtain the average diameter of the Si phase. Herein, an average value obtained by Area average was used for average calculation. In calculating the average diameter of the Si phase in the L cross-section, only Si phases having a diameter (equivalent circle diameter) equal to or larger than 0.5 $\mu$m were considered as targets.

The average diameter of the Si phase was calculated as an average value of respective values obtained for measurement regions at three parts through the procedures from (1) to (3) described above. The average diameter of the Al phase in the L cross-section of the Al connection material was also measured through the same procedure.

(Method for evaluating Al connection material)

The following describes a method for evaluating the Al connection material. The wire diameter of the Al connection material (Al bonding wire) used for evaluation was $\Phi$300 $\mu$m. The semiconductor chip made of Si was used, and as the electrode on the semiconductor chip, used was an alloy having a composition of Al-0.5%Cu deposited to have a thickness of 4 $\mu$m. As a substrate, 15 $\mu$m of Ni was deposited on an Al alloy. For bonding of the Al connection material, a commercially available wire bonder (manufactured by ULTRASONIC ENGINEERING CO., LTD.) was used, and wedge bonding was used for both of the 1st bonding and the 2nd bonding.

(Method for evaluating temperature cycle reliability)

For evaluation in the temperature cycle test, a commercially available thermal shock test device was used. In the temperature cycle test, a temperature rise and a temperature fall are repeated when a sample chamber moves between a low-temperature tank and a high-temperature tank. A temperature of the low-temperature tank was -40°C, and a temperature of the high-temperature tank was 175°C. The test was started in a state in which the sample chamber was present in the high-temperature tank, and a period from when the sample chamber moved to the low-temperature tank until it returned to the high-temperature tank was one cycle. A time during which the sample chamber stayed in each of the low-temperature tank and the high-temperature tank was 20 minutes. A sample to be subjected to the temperature cycle test had a structure in which a semiconductor chip was mounted on a substrate, and an electrode on the semiconductor chip was connected with an electrode on the substrate via the Al connection material. After the test was started, the sample was taken out every 250 cycles, and a shear test was performed on the 1st bonding part. As a value of shear force of the 1st bonding part used for evaluating the temperature cycle reliability, an average value of shear force of 1st bonding parts at five points, which were randomly extracted, was used. The number of cycles at the time when the shear force was lowered to 70% or less of a value before the temperature cycle test was a lifetime of wire bond. If the lifetime of wire bond was shorter than 500 cycles, it was determined that there was a problem in a practical use and the value was determined to be "0". If the lifetime of wire bond was equal to or longer than 500 cycles and shorter than 750 cycles, it was determined that there was no problem in a practical use and the value was determined to be "1". If the lifetime of wire bond was equal to or longer than 750 cycles and shorter than 1000 cycles, it was determined to be excellent and the value was determined to be "2". If the lifetime of wire bond was equal to or longer than 1000 cycles, it was determined to be especially excellent and the value was determined to be "3". "0" is unacceptable, and "1", "2", and "3" are acceptable. Evaluation results are described in a column of "Temperature cycle reliability" in tables.

(Method for evaluating internal crack)

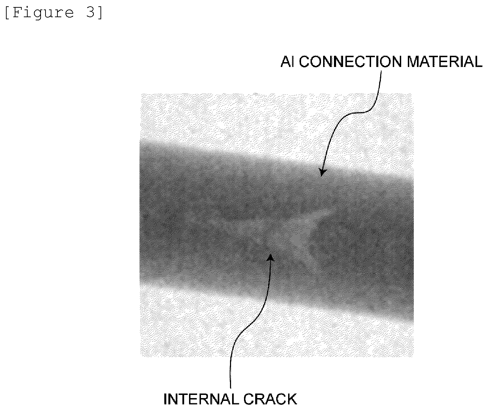

The following describes a method for evaluating an internal crack of the Al connection material. The manufactured Al connection material was evaluated by observation using a soft X-ray projection inspection device ($\mu$B2600, manufactured by Matsusada Precision Inc.) (hereinafter, referred to as X-ray observation). A measurement condition for X-ray observation may be appropriately determined in accordance with the wire diameter of the Al connection material. In a case of the Al connection material having a wire diameter of 300 $\mu$m manufactured in this example, a voltage was adjusted in a range from 50 to 80 kV, and a current was adjusted in a range from 60 to 90 $\mu$A. Three parts were randomly selected at intervals of 1 m or more with respect to the center axis direction of the Al connection material, and three samples each having a length of about 8 cm were selected at each of the three parts to make nine measurement samples in total. FIG. 3 illustrates an example of X-ray observing the Al connection material having a wire diameter of 300 $\mu$m, and an internal crack is observed. If a length of the internal crack was equal to or larger than 0.3 mm, it was determined to be a problematic defect and marked with a score of "2". If the length thereof was equal to or larger than 0.1 mm and smaller than 0.3 mm, it was determined that attention should be paid, and marked with a score of "0.5". A total score of the measurement parts was set as a "crack index". If the crack index of the entire measurement sample was zero, it was determined to be favorable and evaluated as "3". If the crack index fell within a range from 0.1 to 2.0, it was determined that there was no problem in a practical use and evaluated as "2". If the crack index fell within a range from 2.0 to 5.0, it was determined that improvement was required and evaluated as "1". If the crack index exceeded 6.0, it was determined that a practical use is difficult to be achieved and evaluated as "0". Evaluation results are described in a column of "Internal crack" in the tables.

(Method for evaluating wire breakage during processing)

The following describes a method for evaluating wire breakage during processing. Wire-drawing processing was performed from a wire diameter of 6 mm$\varphi$ to a wire diameter of 0.3 mm$\varphi$, and the number of times of wire breakage was checked. The feeding speed, the area reduction ratio, and the like as processing conditions for wire-drawing are selected from the conditions described above, and appropriate manufacturing conditions are adjusted or changed for each wire. The length of the drawn Al connection material fell within a range from 100 to 200 m, and the number of times of wire breakage was calculated in terms of 100 m. If the number of times of wire breakage was 0, it was determined to be favorable and evaluated as "3". If the number of times of wire breakage was 1, it was determined to be able to be handled by improving the manufacturing condition and evaluated as "2". If the number of times of wire breakage was 2 to 4, lowering of productivity was regarded as a problem and evaluated as "1". If the number of times of wire breakage was 5 or more, it was determined that a practical use was difficult to be achieved and evaluated as "0". Evaluation results are described in a column of "Wire breakage during processing" in the tables.

(Method for evaluating hollow at 1st bonding part)

The following describes a method for evaluating a hollow defect at the 1st bonding part. After performing the shear force test on the 1st bonding part described above, an impression on a broken surface on the electrode side was observed by an optical microscope or an SEM, and a part where metallic bonding is not achieved in a broken region was determined to be a hollow. The part where the hollow is generated is a part that is not bonded even when the electrode is deformed, and can be discriminated from a region in which metal bonding is achieved. The shear force test was performed under the condition described above, and broken surfaces at ten parts of the 1st bonding part were observed. A ratio of a total length (K) of a hollow region in a bonding width direction to a bonding length (J) in the vertical direction (bonding width direction) with respect to the center axis of the Al connection material was obtained as a hollow ratio (K/J) (FIG. 2). Hollow ratios are checked for the broken surfaces at ten parts, and a maximum value thereof is defined as a "hollow defect rate". If the hollow defect rate was smaller than 5%, it was determined to be favorable and evaluated as "3". If the hollow defect rate was equal to or larger than 5% and smaller than 15%, it was determined that there was no problem in a practical use and evaluated as "2". If the hollow defect rate was equal to or larger than 15% and smaller than 25%, it was determined that improvement was required and evaluated as "1". If the hollow defect rate exceeded 25%, it was determined to be an obstruction to mass production and evaluated as "0". Evaluation results are described in a column of "Hollow at 1st bonding part" in the tables.

(Method for evaluating stability of bonding length)

The following describes a method for evaluating stability of the bonding length. Evaluation was performed based on an impression length (bonding length) of an impression on a broken surface on the electrode side after performing the shear force test on the 1st bonding part described above. Specifically, for the impression on the broken surface, a bonding part length ($\mu$m) in the center axis direction of the Al connection material was measured, and a population standard deviation ($\sigma$) was calculated. If $\sigma$ was equal to or larger than 15, it was determined that there was a problem in a practical use, and evaluated as "1". If $\sigma$ was equal to or larger than 5 and smaller than 15, it was determined to be favorable and evaluated as "2". If $\sigma$ was smaller than 5, it was determined to be excellent and evaluated as "3". "1" is unacceptable, and "2" and "3" are acceptable. Evaluation results are described in a column of "Stability of bonding length" in the tables.

(Method for evaluating scratch and scrape on surface)

A surface property of the Al connection material was evaluated focusing on scratches and scrapes. The wire diameter of the Al connection material was set to be 0.3 mm$\varphi$. Measurement regions at three parts were randomly selected at intervals of 1 m or more with respect to the center axis direction of the Al connection material, and three samples each having a length of about 2 cm were taken at each of the three parts to observe nine samples in total. The surface was observed with magnification in a range from 50-fold to 500-fold of the SEM. A scratch having a length equal to or larger than 50 $\mu$m or a scrape having a length equal to or larger than 30 $\mu$m were determined to be defects. Parts of scratches and scrapes were counted. If the number thereof was 0, it was determined to be favorable and acceptable, and evaluated as "3". If the number thereof was equal to or smaller than 2, it was determined that there was no problem in a practical use and evaluated as "2". If the number thereof was 3 to 7, it was determined that the surface property was not good, and evaluated as "1". If the number thereof was 8 or more, it was determined that a practical use was difficult to be achieved and evaluated as "0". Evaluation results are described in a column of "Surface property" in the tables.

The evaluation results of Examples and Comparative Examples are indicated in Table 1 to Table 3.

[Table 1]

(Table 1)

| | No. | Si (% by mass) | Sr (mass ppm) | Na (mass ppm) | Eu (mass ppm) | Ca (mass ppm) | Ti (mass ppm) | B (mass ppm) | Zr (mass ppm) | Ni (mass ppm) | Y (mass ppm) | Yb (mass ppm) | Sc (mass ppm) | Total content of first element group (mass ppm) | Total content of second element group (mass ppm) | Total content of third element group (mass ppm) | <111> + <110> total ratio of Si phase (%) | Average diameter of Si phase (μm) | Temperature cycle reliability | Internal crack | Wire breakage during processing | Hollow at 1st bonding part | Stability of bonding length | Surface property |
|---|---|---|---|---|---|---|---|---|---|---|---|---|---|---|---|---|---|---|---|---|---|---|---|---|
| Example | 1 | 3.0 | 5 | | | | | | | | | | | 5 | 0 | 0 | 38 | 0.9 | 2 | 2 | 3 | 3 | 2 | 1 |
| | 2 | 5.3 | 100 | | | | | | | | | | | 100 | 0 | 0 | 45 | 2.6 | 3 | 3 | 3 | 3 | 2 | 1 |
| | 3 | 8.0 | 600 | | | | | | | | | | | 600 | 0 | 0 | 39 | 2.9 | 3 | 3 | 3 | 3 | 2 | 2 |
| | 4 | 3.8 | | 150 | | | | | | | | | | 150 | 0 | 0 | 18 | 2.7 | 2 | 3 | 1 | 3 | 2 | 2 |
| | 5 | 6.1 | | 500 | | | | | | | | | | 500 | 0 | 0 | 42 | 2.2 | 3 | 3 | 3 | 3 | 2 | 2 |
| | 6 | 4.0 | | | 50 | | | | | | | | | 50 | 0 | 0 | 43 | 2.5 | 3 | 3 | 3 | 3 | 2 | 2 |
| | 7 | 7.3 | | | 400 | | | | | | | | | 400 | 0 | 0 | 63 | 4.0 | 3 | 3 | 3 | 3 | 2 | 2 |
| | 8 | 10.0 | | | 700 | | | | | | | | | 700 | 0 | 0 | 34 | 3.5 | 3 | 3 | 3 | 3 | 2 | 2 |
| | 9 | 7.2 | | | | 100 | | | | | | | | 100 | 0 | 0 | 20 | 3.2 | 3 | 3 | 2 | 3 | 2 | 2 |
| | 10 | 6.5 | | | | 800 | | | | | | | | 800 | 0 | 0 | 65 | 2.4 | 3 | 2 | 3 | 3 | 2 | 2 |
| | 11 | 7.0 | 3 | | 2 | | | | | | | | | 5 | 0 | 0 | 47 | 3.2 | 2 | 2 | 3 | 3 | 2 | 2 |
| | 12 | 8.8 | 20 | | 10 | 100 | | | | | | | | 130 | 0 | 0 | 42 | 4.1 | 3 | 3 | 3 | 2 | 2 | 2 |
| | 13 | 4.4 | | 50 | 100 | 30 | | | | | | | | 180 | 0 | 0 | 55 | 2.2 | 3 | 3 | 3 | 3 | 2 | 2 |
| | 14 | 6.8 | 100 | 100 | | | | | | | | | | 200 | 0 | 0 | 42 | 2.4 | 3 | 3 | 3 | 3 | 2 | 2 |
| | 15 | 3.1 | 200 | 100 | 100 | | | | | | | | | 400 | 0 | 0 | 40 | 0.7 | 2 | 3 | 3 | 2 | 2 | 2 |
| | 16 | 4.4 | 300 | | | 200 | | | | | | | | 500 | 0 | 0 | 37 | 0.8 | 3 | 3 | 3 | 3 | 2 | 2 |
| | 17 | 9.1 | | 100 | 300 | | | | | | | | | 400 | 0 | 0 | 32 | 4.0 | 3 | 3 | 3 | 3 | 2 | 2 |
| | 18 | 11.0 | 200 | 100 | 200 | 150 | | | | | | | | 650 | 0 | 0 | 25 | 3.8 | 3 | 2 | 3 | 3 | 2 | 2 |
| | 19 | 12.0 | 100 | 200 | | 50 | | | | | | | | 350 | 0 | 0 | 32 | 3.3 | 3 | 3 | 3 | 3 | 2 | 2 |

[Table 2]

〈Table 2〉

| No. | Si (% by mass) | Sr (mass ppm) | Na (mass ppm) | Eu (mass ppm) | Ca (mass ppm) | Ti (mass ppm) | B (mass ppm) | Zr (mass ppm) | Ni (mass ppm) | Y (mass ppm) | Yb (mass ppm) | Sc (mass ppm) | Total content of first element group (mass ppm) | Total content of second element group (mass ppm) | Total content of third element group (mass ppm) | ⟨111⟩ + ⟨110⟩ total ratio of Si phase (%) | Average diameter of Si phase (μm) | Temperature cycle reliability | Internal crack | Wire breakage during processing | Hollow at 1st bonding part | Stability of bonding length | Surface property |
|---|---|---|---|---|---|---|---|---|---|---|---|---|---|---|---|---|---|---|---|---|---|---|---|
| Example | | | | | | | | | | | | | | | | | | | | | | | |
| 20 | 6.5 | 300 | | | | 10 | | | | | | | 300 | 10 | 0 | 44 | 2.4 | 3 | 3 | 3 | 3 | 3 | 2 |
| 21 | 6.8 | | 100 | | | 400 | | | | | | | 100 | 400 | 0 | 54 | 2.2 | 3 | 3 | 3 | 3 | 3 | 2 |
| 22 | 7.0 | | | 350 | | | 50 | | | | | | 350 | 50 | 0 | 32 | 3.1 | 3 | 3 | 3 | 3 | 3 | 2 |
| 23 | 10.0 | | 150 | | 100 | | | 100 | | | | | 250 | 100 | 0 | 22 | 3.0 | 3 | 3 | 2 | 3 | 3 | 2 |
| 24 | 3.9 | | 100 | | 100 | 2 | 3 | 3 | | | | | 200 | 8 | 0 | 45 | 1.9 | 3 | 3 | 3 | 3 | 3 | 2 |
| 25 | 5.4 | 200 | | 400 | 100 | | | 200 | | | | | 700 | 200 | 0 | 18 | 2.4 | 3 | 3 | 1 | 3 | 2 | 2 |
| 26 | 7.0 | 100 | | | 200 | 200 | | 170 | | | | | 300 | 370 | 0 | 37 | 3.1 | 3 | 3 | 3 | 3 | 3 | 2 |
| 27 | 6.0 | 150 | | 250 | | 100 | 200 | 200 | | | | | 400 | 500 | 0 | 47 | 2.8 | 3 | 3 | 3 | 3 | 3 | 2 |
| 28 | 8.6 | | 100 | 200 | | 400 | | 200 | | | | | 300 | 600 | 0 | 53 | 4.2 | 3 | 3 | 3 | 2 | 2 | 3 |
| 29 | 4.2 | 100 | 100 | | 200 | | | | 50 | | | | 400 | 0 | 50 | 48 | 1.5 | 3 | 3 | 3 | 3 | 2 | 3 |
| 30 | 7.0 | 100 | | 400 | | | | | 350 | | | | 500 | 0 | 350 | 41 | 3.2 | 3 | 3 | 3 | 3 | 2 | 3 |
| 31 | 5.5 | 300 | | | | | | | | 5 | | | 300 | 0 | 5 | 25 | 2.2 | 3 | 3 | 3 | 3 | 2 | 3 |
| 32 | 6.5 | | | 350 | 300 | | | | | 200 | | | 650 | 0 | 200 | 55 | 2.5 | 2 | 2 | 3 | 3 | 2 | 3 |
| 33 | 9.0 | 200 | | | | | | | | | 5 | | 200 | 0 | 5 | 45 | 2.3 | 3 | 3 | 3 | 3 | 2 | 3 |
| 34 | 5.5 | | 100 | | | | | | | | 100 | | 100 | 0 | 100 | 70 | 2.2 | 3 | 3 | 3 | 3 | 2 | 3 |
| 35 | 6.2 | | | 300 | 200 | | | | | | | 100 | 500 | 0 | 100 | 48 | 2.2 | 3 | 3 | 3 | 3 | 2 | 3 |
| 36 | 6.0 | | | 300 | | | | | | | | 500 | 300 | 0 | 500 | 46 | 2.8 | 3 | 3 | 3 | 3 | 2 | 3 |
| 37 | 4.4 | 7 | | | | | | | | 2 | 2 | | 7 | 0 | 4 | 37 | 1.2 | 2 | 2 | 3 | 3 | 2 | 2 |
| 38 | 8.2 | 300 | 200 | 100 | 200 | | | | 100 | | | 200 | 800 | 0 | 300 | 73 | 3.2 | 3 | 2 | 2 | 3 | 2 | 3 |
| 39 | 7.0 | | | 400 | | | | | | 30 | 170 | 300 | 400 | 0 | 500 | 65 | 2.8 | 3 | 3 | 3 | 3 | 2 | 3 |
| 40 | 6.0 | | | 300 | 100 | | | | 200 | | 100 | 300 | 400 | 0 | 600 | 42 | 2.4 | 3 | 3 | 3 | 3 | 2 | 2 |
| 41 | 11.0 | 300 | | | | 200 | | | 50 | | 20 | | 300 | 200 | 70 | 27 | 2.2 | 3 | 3 | 3 | 3 | 2 | 3 |
| 42 | 7.1 | | | 400 | | | 20 | 50 | 30 | 20 | 50 | | 400 | 70 | 70 | 42 | 2.3 | 3 | 3 | 3 | 3 | 3 | 3 |
| 43 | 6.5 | | 100 | 100 | 300 | | | | 50 | | 100 | 100 | 500 | 100 | 230 | 37 | 2.2 | 3 | 3 | 3 | 3 | 3 | 3 |
| 44 | 5.0 | 100 | | | | 50 | | 200 | 50 | 5 | | | 100 | 250 | 55 | 52 | 1.8 | 3 | 3 | 3 | 3 | 3 | 3 |
| 45 | 10.5 | 200 | 50 | | 50 | 50 | 20 | 400 | | 10 | 5 | | 300 | 500 | 15 | 38 | 2.3 | 3 | 3 | 3 | 3 | 3 | 3 |
| 46 | 5.8 | | | 450 | 100 | | 20 | 80 | 100 | | | 300 | 450 | 100 | 400 | 36 | 1.8 | 3 | 3 | 3 | 3 | 3 | 3 |
| 47 | 7.7 | 300 | | 100 | 100 | 50 | | 300 | 100 | 100 | 100 | 200 | 500 | 350 | 500 | 27 | 2.3 | 3 | 3 | 3 | 3 | 3 | 3 |

[Table 3]

(Table 3)

| | No. | Si (% by mass) | Sr (mass ppm) | Na (mass ppm) | Eu (mass ppm) | Ca (mass ppm) | Ti (mass ppm) | B (mass ppm) | Zr (mass ppm) | Ni (mass ppm) | Y (mass ppm) | Yb (mass ppm) | Sc (mass ppm) | Total content of first element group (mass ppm) | Total content of second element group (mass ppm) | Tota content of third element group (mass ppm) | ⟨111⟩ + ⟨110⟩ total ratio of Si phase (%) | Average diameter of Si phase (μm) | Temperature cycle reliability | Internal crack | Wire breakage during processing | Hollow at 1st bonding part | Stability of bonding length | Surface property |
|---|---|---|---|---|---|---|---|---|---|---|---|---|---|---|---|---|---|---|---|---|---|---|---|---|
| Comparative example | 1 | 0.0 | | | | | | | | | | | | 0 | 0 | 0 | — | — | 0 | 3 | 2 | 3 | 3 | 2 |
| | 2 | 2.5 | | | | | | | | | | | | 0 | 0 | 0 | 15 | 0.5 | 0 | 2 | 2 | 2 | 2 | 2 |
| | 3 | 8.0 | 2 | | | 2 | | | | | | | | 4 | 0 | 0 | 25 | 3.7 | 1 | 0 | 1 | 1 | 1 | 1 |
| | 4 | 7.0 | | 2 | 2 | | | | | | | | | 4 | 0 | 0 | 32 | 1.8 | 1 | 0 | 1 | 1 | 1 | 1 |
| | 5 | 12.5 | 100 | | | 100 | | | | | | | | 200 | 0 | 0 | 45 | 3.3 | 1 | 1 | 0 | 1 | 1 | 1 |
| | 6 | 6.0 | 500 | 400 | | | | | | | | | | 900 | 0 | 0 | 38 | 2.2 | 1 | 1 | 1 | 1 | 1 | 2 |
| | 7 | 5.5 | | 300 | 200 | 350 | | | | | | | | 850 | 0 | 0 | 27 | 4.0 | 1 | 1 | 1 | 1 | 1 | 2 |

18

EP 4 632 091 A1

**EP 4 632 091 A1**

It was confirmed that all Al connection materials in Examples Nos. 1 to 47 contained 3.0% by mass or more and 12.0% by mass or less of Si, and contained 5 mass ppm or more and 800 mass ppm or less of one or more elements of the first element group (Sr, Na, Eu, Ca) in total, so that generation of internal cracks at the time of manufacture was able to be suppressed, and favorable temperature cycle reliability was exhibited.

Additionally, it was confirmed that, with the Al connection materials in Examples Nos. 1 to 3, 5 to 24, 26 to 37, and 39 to 47 in which the <111> + <110> total ratio of the Si phase in the L cross-section was equal to or larger than 20% and equal to or smaller than 70%, more favorable temperature cycle reliability tends to be obtained, and a generation frequency of wire breakage during processing was able to be reduced.

It was confirmed that a hollow at the 1st bonding part was able to be suppressed with the Al connection materials in Examples Nos. 1 to 11, 13, 14, 16 to 27, and 29 to 47 in which the average diameter of the Si phase in the L cross-section was equal to or larger than 0.8 $\mu$m and equal to or smaller than 4 $\mu$m. It was confirmed that, with the Al connection material in which the average diameter of the Al phase in the L cross-section was equal to or larger than 5 $\mu$m and equal to or larger than 40 $\mu$m, a more favorable result was easily obtained regarding bonding strength stability of the 2nd bonding part.

Furthermore, it was confirmed that, with the Al connection materials in Examples Nos. 20 to 23, 25 to 27, and 41 to 47 containing 10 mass ppm or more and 500 mass ppm or less of one or more elements of the second element group (Ti, B, Zr) in total, variations in the bonding length at the time of bonding were reduced, and the bonding length was able to be stabilized.

It was also confirmed that, with the Al connection materials in Examples Nos. 29 to 36, 38, 39, and 41 to 47 containing 5 mass ppm or more and 500 mass ppm or less of one or more elements of the third element group (Ni, Y, Yb, Sc) in total, generation of scratches and scrapes on the surface was suppressed and a smooth surface was obtained.

On the other hand, it was confirmed that, with the Al connection materials in Comparative Examples Nos. 1 to 7, any of the Si concentration and the concentration of the first element group was out of the ranges of the present invention, and any of the effect of suppressing generation of internal cracks at the time of manufacture and the temperature cycle reliability was not sufficiently obtained.

**Claims**

1. An Al connection material containing:

   3.0% by mass or more and 12.0% by mass or less of Si; and
   5 mass ppm or more and 800 mass ppm or less of one or more of Sr, Na, Eu, and Ca in total.

2. The Al connection material according to claim 1, wherein, when a crystal orientation of a Si phase in an L cross-section (cross section in a center axis direction including a center axis) of the Al connection material is measured, a total of orientation ratios of a <111> crystal orientation and a <110> crystal orientation angled at 15° or less to the center axis direction is equal to or larger than 20% and equal to or smaller than 70%.

3. The Al connection material according to claim 1 or 2, wherein an average diameter of a Si phase in the L cross-section is equal to or larger than 0.8 $\mu$m and equal to or smaller than 4 um.

4. The Al connection material according to any one of claims 1 to 3, further containing 10 mass ppm or more and 500 mass ppm or less of one or more of Ti, B, and Zr in total.

5. The Al connection material according to any one of claims 1 to 4, further containing 5 mass ppm or more and 500 mass ppm or less of one or more of Ni, Y, Yb, and Sc in total.

[Figure 1]

L CROSS-SECTION
(CROSS SECTION IN
CENTER AXIS DIRECTION
INCLUDING CENTER AXIS)

CENTER AXIS OF
Al CONNECTION MATERIAL

[Figure 2]

BROKEN PART

HOLLOW

J

K

[Figure 3]

AI CONNECTION MATERIAL

INTERNAL CRACK

## INTERNATIONAL SEARCH REPORT

| International application No. |
|---|
| **PCT/JP2023/042371** |

| A. | CLASSIFICATION OF SUBJECT MATTER |
|---|---|

*C22C 21/02*(2006.01)i; *C22F 1/00*(2006.01)i; *C22F 1/043*(2006.01)i; *H01L 21/60*(2006.01)i
FI: C22C21/02; C22F1/043; C22F1/00 605; C22F1/00 614; C22F1/00 625; C22F1/00 630G; C22F1/00 650A; C22F1/00 661Z; C22F1/00 681; C22F1/00 682; C22F1/00 685Z; C22F1/00 686A; C22F1/00 691B; C22F1/00 691C; C22F1/00 691Z; C22F1/00 694A; C22F1/00 694Z; H01L21/60 301F

According to International Patent Classification (IPC) or to both national classification and IPC

| B. | FIELDS SEARCHED |
|---|---|

Minimum documentation searched (classification system followed by classification symbols)

C22C21/02; C22F1/00; C22F1/043; H01L21/60

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| X | JP 2022-533827 A (NOVELIS, INC.) 26 July 2022 (2022-07-26) claim 15, paragraph [0061], examples, table 6 | 1, 4-5 |
| A | | 2-3 |
| X | CN 110656263 A (INSTITUTE OF METAL RESEARCH, CHINESE ACADEMY OF SCIENCES) 07 January 2020 (2020-01-07) claim 1, paragraphs [0025]-[0029], fig. 3b | 1, 3-4 |
| A | | 2, 5 |
| X | CN 105331856 A (JIANGSU HENGTONG ELECTRIC POWER SPECIALTY WIRE CO., LTD.) 17 February 2016 (2016-02-17) claims 1, 4, 8 | 1 |
| A | | 2-5 |

☐ Further documents are listed in the continuation of Box C.　　☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| | |
|---|---|
| "T" | later document published after the international filing date or priority date and not in conflict with the application but cited to understand the principle or theory underlying the invention |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **05 January 2024** | **30 January 2024** |

| Name and mailing address of the ISA/JP | Authorized officer |
|---|---|
| **Japan Patent Office (ISA/JP)** 3-4-3 Kasumigaseki, Chiyoda-ku, Tokyo 100-8915 Japan | |
| | Telephone No. |

Form PCT/ISA/210 (second sheet) (July 2022)

## INTERNATIONAL SEARCH REPORT
### Information on patent family members

International application No.

**PCT/JP2023/042371**

| Patent document cited in search report | | | Publication date (day/month/year) | Patent family member(s) | | Publication date (day/month/year) |
|---|---|---|---|---|---|---|
| JP | 2022-533827 | A | 26 July 2022 | US 2022/0324065 A1 claim 15, paragraph [0061], examples, table 6 WO 2020/236373 A1 EP 3972775 A1 KR 10-2022-0003083 A CN 113924185 A CA 3138936 A1 | | |
| CN | 110656263 | A | 07 January 2020 | (Family: none) | | |
| CN | 105331856 | A | 17 February 2016 | (Family: none) | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2014131010 A
- JP 2014129578 A
- JP 59057440 A
- JP 2020150116 A